## Europäisches Patentamt
## European Patent Office
## Office européen des brevets

(11) Numéro de publication: **0 114 768**
**B1**

(12) # FASCICULE DE BREVET EUROPÉEN

(45) Date de publication du fascicule du brevet:
**08.04.87**

(51) Int. Cl.⁴: **H 04 N 1/18**

(21) Numéro de dépôt: **84400091.9**

(22) Date de dépôt: **17.01.84**

(54) Dispositif photosensible à transfert de charge.

(30) Priorité: **21.01.83 FR 8300917**

(43) Date de publication de la demande:
**01.08.84 Bulletin 84/31**

(45) Mention de la délivrance du brevet:
**08.04.87 Bulletin 87/15**

(84) Etats contractants désignés:
**DE GB NL**

(56) Documents cité:
**EP-A-0 060 149**
**DE-A-2 304 448**
**US-A-3 911 467**

**PATENTS ABSTRACTS OF JAPAN, vol. 6, no. 147, 6 août 1982, page 19 E 123**
**PATENTS ABSTRACTS OF JAPAN**
**RESEARCH DISCLOSURE, no. 202, février 1981, pages 103-104, disclosure no. 20242, Havant, Hampshire, GB, W.A. MONETTE: "Integratable gray scale generator"**

(73) Titulaire: **THOMSON- CSF, 173, Boulevard Haussmann, F-75379 Paris Cedex 08 (FR)**

(72) Inventeur: **Boucharlat, Gilles, THOMSON- CSF SCPI 173, bld Haussmann, F-75379 Paris Cedex 08 (FR)**
Inventeur: **Chabbal, Jean, THOMSON CSF SCPI 173, bld Haussmann, F-75379 Paris Cedex 08 (FR)**

(74) Mandataire: **Mayeux, Michèle, THOMSON- CSF SCPI 19, avenue de Messine, F-75008 Paris (FR)**

## Description

La présente invention concerne un dispositif photosensible à transfert de charge, du type linéaire.

Les dispositifs photosensibles à transfert de charge linéaires sont bien connus de l'art antérieur. Ces dispositifs comportent généralement une "barrette" constituée d'éléments photosensibles alignés. L'image à analyser est projetée ligne après ligne sur la barrette: c'est soit la barrette, soit l'image à analyser qui se déplace. On peut aussi utiliser un élément optique qui projette ligne après ligne, l'image à analyser, immobile, sur la barrette, immobile.

Les charges accumulées dans la barrette sont périodiquement transférées en parallèle dans un registre à décalage à transfert de charge, puis transférées en série vers la sortie du registre où elles sont lues, c'est-à-dire converties en une tension qui est amplifiée.

C'est le registre à décalages à transfert de charge qui par ses dimensions conditionne les dimensions minimales que l'on peut donner aux éléments photosensibles de la barrette, et donc la résolution du dispositif.

En conséquence, on utilise généralement deux registres à décalages situés de part et d'autre de la barrette. Chaque registre traite la moitié des éléments photosensibles et cela permet de doubler la résolution en doublant le nombre des éléments photosensibles adressables.

La résolution des dispositifs photosensibles reste quand même limitée par les dimensions des registres à décalage utilisés.

Par exemple, dans le cas d'un registre à décalage à transfert de charge à structure biphasée, dans lequel la dissymétrie est assurée par surépaisseur d'oxyde, chaque étage du registre qui traite un élément photosensible occupe environ 20µm.

Si l'on utilise deux registres, les éléments photosensibles ont un pas qui ne peut être inférieur à 10µm.

Plusieurs solutions ont été proposées pour diminuer le pas, parmi lesquelles on peut citer:
- l'utilisation de registres en serpentins, qui présentent notamment l'inconvénient d'être difficiles à dessiner;
- le doublement du nombre de registres, c'est-à-dire l'utilisation de quatre registres au lieu de deux;
- le transfert séquentiel des informations de la barrette vers les registres, ce transfert séquentiel étant piloté par un registre à décalages logique;
- enfin, l'introduction d'une mémoire entre la barrette photosensible et chaque registre, la mémoire recevant des informations qui sont transférées en deux fois dans chaque registre.

Le problème qui se pose est que les solutions connues permettent généralement de doubler le pas mais doublent sensiblement l'encombrement du dispositif photosensible.

La présente invention résout ce problème et permet de doubler le pas sans augmenter l'encombrement du dispositif.

La présente invention concerne un dispositif photosensible à transfert de charge pour l'analyse d'images, ligne après ligne, comportant:
- une barrette d'éléments photosensibles;
- au moins un registre à décalages à transfert de charge à entrées parallèles et sortie série, deux lectures successives du registre concernant une même ligne de l'image, caractérisé en ce que:
- un élément photosensible sur deux est décalé dans la direction d'analyse de l'image, les éléments étant répartis sur une première et une deuxième rangée;
- des moyens assurent, pour une ligne analysée, le transfert dans le registre et la lecture, successivement, des charges dues à cette ligne et accumulées dans la première rangée d'éléments pendant une durée d'intégration donnée, puis des charges dues à cette ligne et accumulées dans la deuxième rangée d'éléments, pendant la même durée d'intégration.

Le document Patents Abstracts of Japan, volume 6, numero 147, 6 Août 1982, page 19, E 123, A 57 68 971 concerne une barrette de détecteurs photosensibles dont les détecteurs sont lus en deux étapes. Au cours de chaque étape, on lit un détecteur sur deux. Cette lecture en deux étapes permet, avec des registres à décalages à transfert de charge, de dimensions données, de multiplier par deux le nombre de détecteurs de la barrette, et donc d'accroître la résolution. Dans ce mode de fonctionnement, la barrette reçoit chaque ligne de l'image à analyser pendant un temps d'exposition donné, puis il y a un temps d'arrêt pendant lequel s'effectue la lecture en deux étapes avant que la barrette ne reçoive la ligne suivante à analyser.

Dans le document EP-A- 0 060 149, le résultat recherché est l'obtention d'un réseau hexagonal, qui permet certains types de traitement de l'image intéressants. Pour obtenir ce résultat, ce brevet propose d'utiliser des colonnes de détecteurs - telle que celle representée sur la figure 6 - où l'on trouve deux séries de détecteurs hexagonaux et décalés de façon à avoir un côté commun (voir page 1, lignes 13 à 16, 31 à 35). La figure 1 de cette demande de brevet européen montre qu'une mémoire 5 est utilisée.

La géométrie adoptée pour la barrette photosensible permet, sans qu'il soit nécessaire d'avoir une mémoire, d'utiliser deux fois de suite le même registre pour analyser une même ligne. On peut donc doubler la résolution de la barrette pour un encombrement donné du dispositif photosensible.

Le dispositif selon l'invention presente l'avantage dans certains de ses modes de réalisation de permettre d'obtenir un temps d'intégration réglable.

Cela permet d'adapter le temps d'intégration, et donc la sensibilité du dispositif, à l'éclairement reçu.

**0 114 768**

Cela permet aussi de diminuer le temps d'intégration pour ne pas mélanger l'information de plusieurs lignes, lorsque l'on augmente la vitesse de déplacement de l'image sur la barrette, afin d'améliorer la résolution transversale, c'est-à-dire la résolution dans le sens du défilement de l'image.

Dans un de ses modes de réalisation, le dispositif selon l'invention permet de disposer de deux résolutions. Ce dispositif peut alors être utilisé, par exemple, dans un télécopieur ayant deux standards.

D'autres objets, caractéristiques et résultats de l'invention ressortiront de la description suivante, donnée à titre d'exemple non limitatif et illustrée par les figures annexées qui représentent:
- la figure 1, un schéma de principe du dispositif selon l'invention;
- la figure 2, un diagramme montrant l'enchaînement des différentes étapes de traitement d'une ligne de l'information dans le cas du dispositif de la figure 1;
- la figure 3, le schéma d'un mode de réalisation préféré de l'invention;
- les figures 4a et b, des schémas montrant la structure d'un registre à deux phases et expliquant son fonctionnement;
- les figures 5 et 6, des schémas montrant comment peut être intégré le dispositif représenté sur la figure 3;
- les figures 7a à c et 8a à c, les signaux de commande appliqués aux dispositifs des figures 5 et 6;
- les figures 9a et b, une vue en coupe transversale et un schéma expliquant le fonctionnement d'un dispositif selon l'invention à temps d'intégration variable;
- les figure 10a à e, les signaux de commande appliqués aux dispositifs à temps d'intégration variable;
- les figures 11a et b et 13a, b et c, des vues en coupe transversale et des schémas expliquant le fonctionnement d'un dispositif selon l'invention ayant deux résolutions;
- les figures 12a à c et 14, a, b et c, les signaux de commande appliqués aux dispositifs ayant deux résolutions.

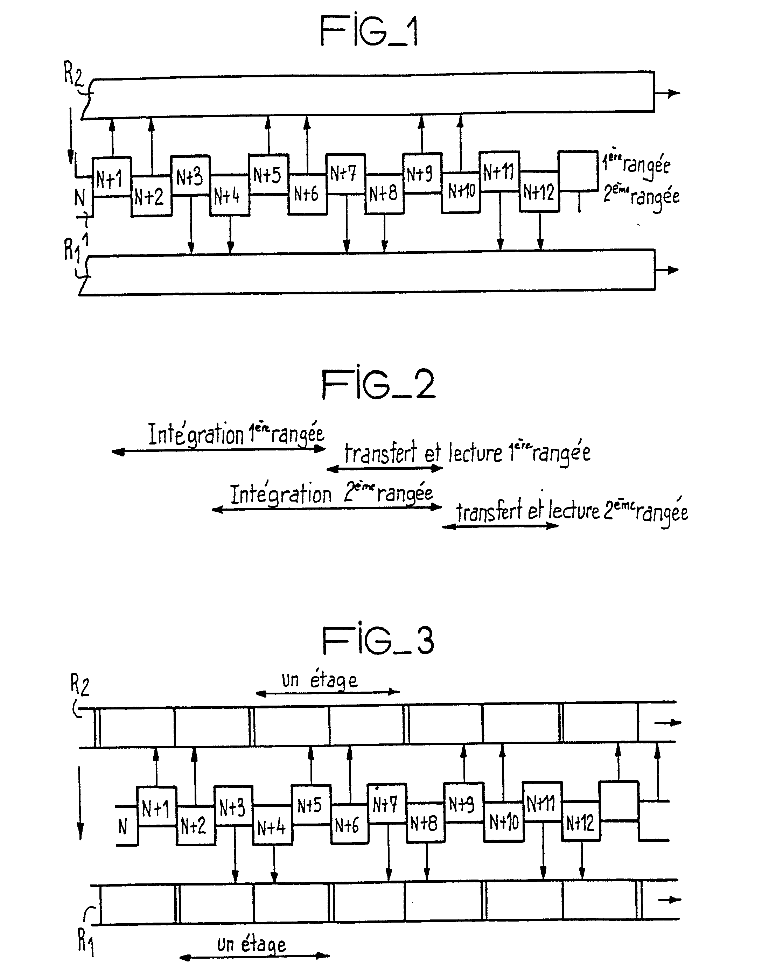

La figure 1 est un schéma de principe du dispositif selon l'invention.

Il s'agit donc d'un dispositif du type linéaire qui comporte une barrette photosensible 1 constituée d'une pluralité d'éléments photosensibles. Sur la figure 1, les éléments photosensibles sont représentes par des carrés appelés N, N+1, N+2... Un élément photosensible sur deux est décalé dans la direction d'analyse de l'image qui est verticale comme cela est représenté par une flèche sur la figure. Les éléments photosensibles N, N+2, N+4, N+6... sont répartis selon une première rangée et les éléments photosensibles intermédiaires N+1, N+3, N+5..., sont répartis selon une deuxième rangée qui, à titre d'exemple, est décalée verticalement par rapport à la première de la moitié du côté des points photosensibles.

Comme cela a été dit dans l'introduction à la description, on utilise généralement deux registres à décalages à transfert de charge $R_1$ et $R_2$ qui sont situés de part et d'autre de la barrette. Il s'agit de registres à entrées parallèles et à sortie série. Chaque registre traite la moitié des éléments photosensibles.

Sur la figure 1, le registre $R_2$ est relié aux points photosensibles N+1, N+2, N+5, N+6... et le registre $R_1$ aux points N+3, N+4, N+7, N+8... Il est bien sûr possible de répartir différemment les points photosensibles de la barrette entre les deux registres.

Il est préférable que chaque registre traite des éléments photosensibles appartenant aux deux rangées de la barrette, car comme ces deux rangées sont transférées dans les registres à des instants différents, on peut ainsi diminuer les dimensions des registres et augmenter la résolution de la barrette.

Selon l'invention, des moyens, qui ne sont pas représentés sur la figure 1, assurent, pour chaque ligne analysée, le transfert dans les registres et la lecture, successivement, des charges dues à cette ligne et accumulées dans la première rangée d'éléments, pendant une durée d'intégration donnée, puis des charges dues à cette ligne et accumulées dans la deuxième rangée d'éléments, pendant la même durée d'intégration. Ce mécanisme va être expliqué dans ce qui suit.

Chaque ligne de l'image à analyser balaie à vitesse constante la surface de la barrette photosensible. Elle balaie d'abord la première rangée d'éléments. Comme cela est représenté schématiquement sur la figure 2, il y a d'abord intégration des charges dues à une ligne de l'image par la première rangée d'éléments. Une fois l'intégration terminée, le contenu de la première rangée est transféré dans les registres. L'intégration des charges dues à la même ligne de l'image par la deuxième rangée d'éléments commence au milieu de la période d'intégration des charges par la première rangée à cause du décalage de la moitié de la hauteur des points photosensibles adopté sur la figure 1. Lorsque cette intégration se termine, les charges en provenance de la première rangée doivent avoir quitté les registres, car le transfert dans les registres des charges provenant de la deuxième rangée commence alors,... et ainsi de suite pour chaque ligne de l'image à analyser, la géométrie de la barrette permet d'utiliser deux fois de suite le même registre pour traiter les informations en provenance de la même ligne de l'image à analyser.

Selon l'invention lesdits moyens assurent aussi l'adaptation de la vitesse de déplacement de chaque ligne à analyser sur la barrette au décalage entre les deux rangées de points photosensibles de façon que deux lectures successives du registre concernent une même ligne de l'image.

La figure 3 représente le schéma d'un mode de réalisation préféré de l'invention dans lequel on utilise des registres à décalage à transfert de charge $R_1$ et $R_2$ dans lesquels chaque étage du registre comporte deux entrées des charges.

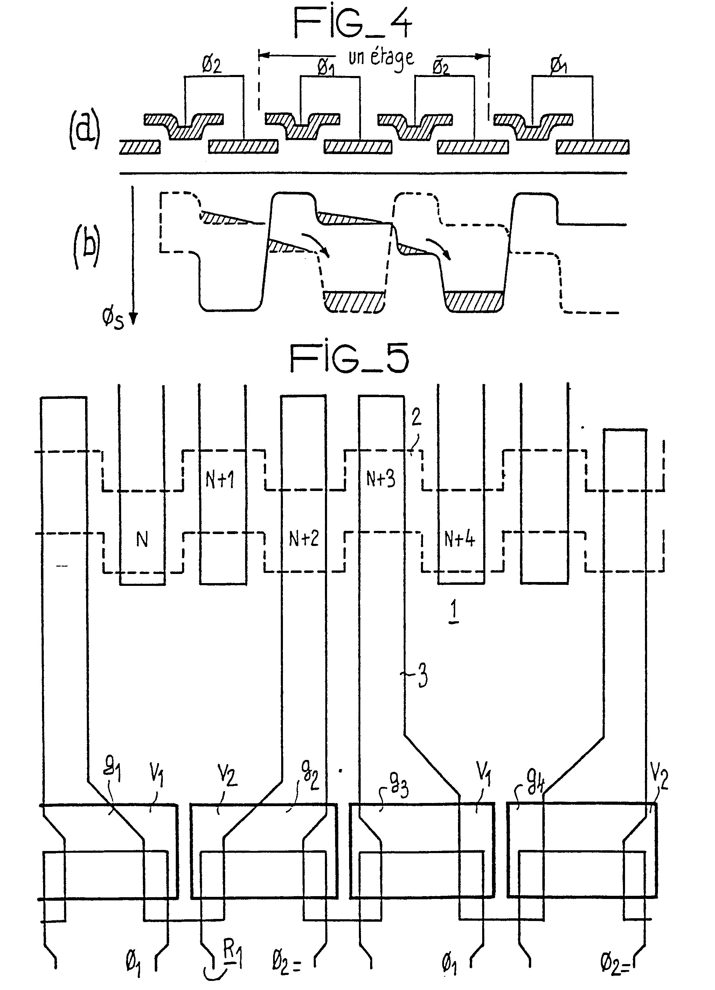

Il s'agit, par exemple, de registres fonctionnant en biphasé ou en monophasé. On a représenté sur la figure 4a, vu en coupe transversale, un étage d'un registre fonctionnant en biphasé. Cet étage est constitué de quatre électrodes, réunies deux à deux au même signal d'horloge $\emptyset_1$ ou $\emptyset_2$. Les deux signaux d'horloge $\emptyset_1$ et $\emptyset_2$ sont en opposition de phase. La figure 4b montre l'évolution des potentiels de surface $\emptyset_S$ dans le substrat lorsque $\emptyset_1$ -traits pleins-ou $\emptyset_2$ - pointillés - est au niveau bas.

Cet étage comporte deux entrées car il est possible, à des instants différents, d'envoyer des charges sous l'électrode de stockage reliée à $\emptyset_1$ ou sous celle reliée à $\emptyset_2$.

Sur la figure 3, chaque étage du registre est délimité par deux traits verticaux et se trouve séparé en deux parties possédant chacune une entrée.

Selon l'invention, les entrées des registres utilisés sont reliées alternativement à la première et à la deuxième rangée d'élements photosensibles.

Sur la figure 3, les points photosensibles $N+1$ et $N+2$ de la première et de la deuxième rangée sont reliés au registre $R_2$, et les points photosensibles $N+3$ et $N+4$ de la première et de la deuxième rangée sont reliés au registre $R_1$. Il est bien sûr possible de répartir différemment les points photosensibles de la barrette entre les deux registres tout en reliant alternativement à la première et à la deuxième rangée les entrées des registres.

Dans les registres à décalage qui sont utilisés - registres dont chaque étage comporte deux parties ayant chacune une entrée des charges - lors d'un transfert, il ne doit y avoir de charges présentes que dans l'une des parties de chaque étage, sous peine de mélanger l'information.

Selon l'invention, on transfère successivement de la barrette vers les registres les informations de la première rangée de la barrette puis les informations de la deuxième rangée. Ainsi, on ne remplit à la fois qu'une partie sur deux de chaque étage et il n'y a pas de mélange de l'information.

On peut donc réduire de moitié le nombre d'étages de ces registres par rapport au nombre de points photosensibles qu'ils traitent.

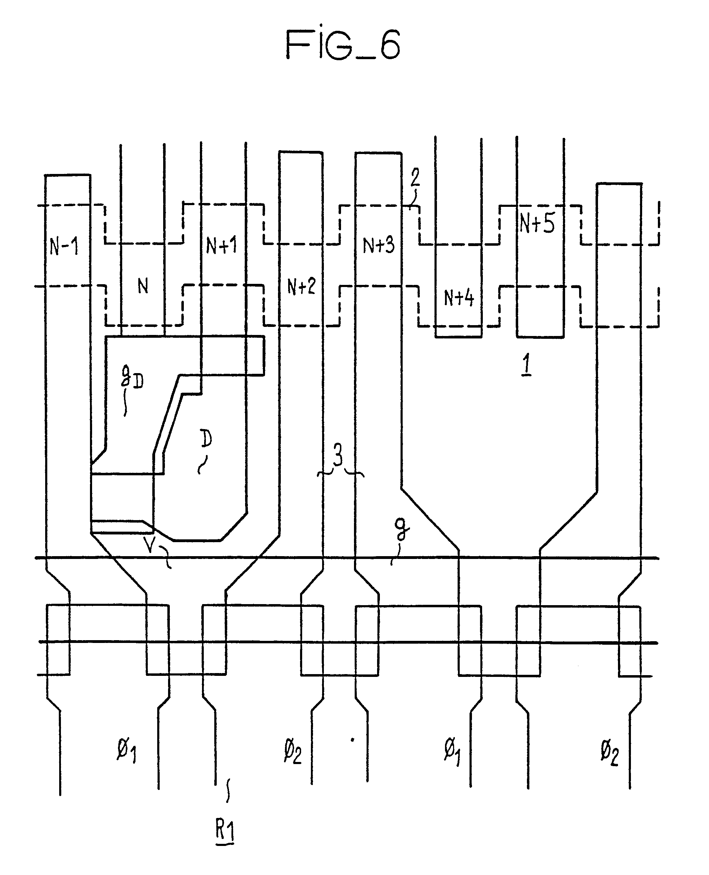

Les figures 5 et 6 montrent comment peut être intégré sur un substrat semi-conducteur le dispositif de la figure 3.

Sur ces figures, on reconnait dessinée en pointillés la barrette 1 de la figure 3. Les pointillés correspondent à une fenêtre 2 réalisée dans un élément opaque pour permettre l'illumination du substrat semi-conducteur.

Dans le substrat semi-conducteur, on réalise, par diffusion par exemple, des zones conductrices 3. Ces zones conductrices ont la forme de rectangles, disposés parallèlement les uns aux autres et régulièrement espacés. Ces rectangles sont en vis-à-vis deux à deux par leur extrêmité pour constituer la barrette et sont reliés par leur base pour constituer les registres.

Ces zones conductrices constituent donc les élément photosensibles N, $N+1$, $N+2$... qui sont des photodiodes ainsi que les connexions des éléments photosensibles aux registres de lecture. Sur les figures 5 et 6, les deux rangées d'éléments photosensibles sont décalées de la moitié de leur hauteur comme sur la figure 3.

Sur les figures 5 et 6, on n'a représenté que le registre $R_1$ de la figure 3, le registre $R_2$ de la figure 3 qui n'a pas été représenté se trouverait dans la partie supérieure des figures 5 et 6. Dans la suite de la description ce qui sera dit à propos du registre $R_1$ pourrait s'appliquer au registre $R_2$.

Sur les figures 5 et 6, on n'a représenté en trait fort que les électrodes de stockage du registre $R_1$.

Il s'agit d'un registre à décalage à transfert de charge comportant des électrodes de stockage et des électrodes de transfert situées sur une surépaisseur d'oxyde, comme le registre représenté sur les figures 4a et b.

Des signaux d'horloge $\emptyset_1$ et $\emptyset_2$ sont appliqués à un couple électrode de stockage - électrode de transfert sur deux. Sur les figures 5 et 6, le signal d'horloge $\emptyset_1$ est appliqué aux électrodes reliées aux éléments de la première rangée et le signal d'horloge $\emptyset_2$ est appliqué aux électrodes reliées aux éléments de la deuxième rangée.

Sur la figure 5, des grilles, représentées en trait fort, commandent le passage des charges provenant des points photosensibles vers le registre. On désigne ces grilles par les référérences $G_1$, $G_2$, $G_3$, $G_4$...Une grille sur deux reçoit un signal de cornmande $V_1$ et l'autre un signal de commande $V_2$.

Sur la figure 6, une seule grille G qui reçoit le signal de commande V contrôle le passage des charges venant de toute la barrette.

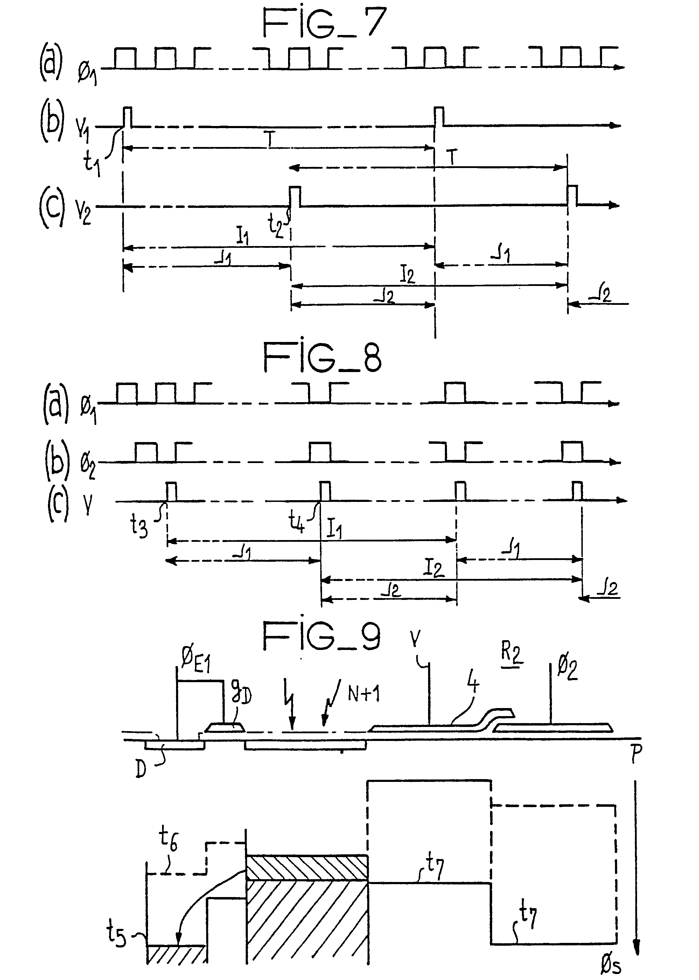

Sur les figures 7a, b et c, on a représenté les signaux de commande appliqués au dispositif de la figure 5.

Le registre $R_1$ de la figure 5 peut fonctionner en monophasé, c'est-à-dire que par exemple le signal $\emptyset_1$ est un signal d'horloge qui varie périodiquement d'un niveau bas à un niveau haut alors que le signal $\emptyset_2$ est constant. La figure 7a montre le signal $\emptyset_1$. Les figures 7b et c montrent les signaux d'horloge $V_1$ et $V_2$ appliqués aux grilles de passage. Ces signaux sont normalement au niveau bas et passent au niveau haut avec une même périodicité T, par exemple lorsque $\emptyset_1$ est au niveau haut.

On considère que les dispositifs des figures 5 et 6 sont intégrés sur un substrat semi-conducteur en silicium par exemple, de type P et donc que lorsqu'un signal d'horloge au niveau haut est appliqué aux grilles $G_1$, $G_2$, $G_3$... ou G, ces grilles permettent le passage des charges des points photosensibles vers les registres.

Sur la figure 7b, au temps $t_1$, $V_1$ passe au niveau haut alors que $\emptyset_1$ se trouve au niveau haut. Il y a transfert dans le registre $R_1$ des

charges intégrées par la première rangée de points photosensibles. Une nouvelle période d'intégration I$_1$ commence pour cette première rangée qui se termine avec le prochain passage de V$_1$ au niveau haut. Les charges transférées dans le registre R$_1$ au temps t$_1$ sont transférées vers la sortie grâce aux signaux d'horloge Ø$_1$ et Ø$_2$.

Sur la figure 7c, au temps t$_2$, V$_2$ passe au niveau haut alors que Ø$_1$ se trouve au niveau haut. Il y a transfert dans le registre R$_1$ des charges intégrées par la deuxième rangée de points photosensibles. Une nouvelle période d'intégration 1$_2$ de durée T égale à celle de I$_1$ commence pour cette deuxième rangée qui se termine avec le prochain passage de V$_2$ au niveau haut, alors que commence le transfert des charges vers la sortie du registre. Les intervalles de temps qui peuvent être utilisés pour transférer les charges des deux rangées sont désignés par J$_1$ et J$_2$ sur la figure 7c.

Sur les figures 7b et c, comme sur la figure 2, les périodes d'intégration I$_1$ et I$_2$ des deux rangées d'éléments photosensibles sont décalées de la moitié de la période d'intégration T ce qui correspond au décalage de la moitié de la hauteur des points photosensibles qui est adopté sur la figure 5.

Il est possible d'adopter pour les deux rangées un décalage différent de ce qui est représenté sur la figure 5. Il faut alors modifier les signaux d'horloge V$_1$ et V$_2$ pour que le recouvrement des périodes I$_1$ et I$_2$ corresponde au décalage des deux rangées. L'inconvénient est que les durées J$_1$ et J$_2$ disponibles pour transférer les charges dans les registres et les évacuer des registres ne sont pas égales. Dans ce mode de réalisation, le décalage entre les deux rangées est de façon préférée égal à la moitié de la hauteur des points photosensibles dans la direction d'analyse de l'image et au minimum égal au produit du temps minimum nécessaire à la lecture d'un registre par la vitesse de déplacement de l'image à analyser sur la barrette.

Pour faire varier la période d'intégration T, il faut agir sur la période des signaux V$_1$ et V$_2$ et sur la fréquence de lecture des registres.

La figure 6 se distingue de la figure 5, parce que le registre à décalage R$_1$ est biphasé et utilise donc deux signaux d'horloge Ø$_1$ et Ø$_2$ en opposition de phase qui varient entre un niveau bas et un niveau haut. Ces signaux sont représentés sur les figures 8a et b.

Le fait que le registre R$_1$ est biphasé permet de n'utiliser qu'une seule grille G entre la barrette et le registre R$_1$ ce qui simplifie la réalisation du dispositif. Cette grille reçoit le signal de commande V représenté sur la figure 8c. Le signal V passe périodiquement au niveau haut et sa périodicité est choisie pour qu'il passe au niveau haut alternativement alors que Ø$_1$ est au niveau haut puis alors que Ø$_2$ est au niveau haut. L'utilisation de registres fonctionnant en polyphasé permet d'utiliser une seule grille G entre la barrette et chaque registre.

Au temps t$_3$, V et Ø$_1$ sont au niveau haut. Les charges integrées par la première rangée de points photosensibles sont transférées dans le registre R$_1$ et décalées vers la sortie. Une nouvelle période d'intégration I$_1$ commence pour la première rangée, elle se terminera lorsque V et Ø$_1$ seront à nouveau au niveau haut.

Au temps t$_4$, V et Ø$_2$ sont au niveau haut. Les charges integrées par la deuxième rangée de points photosensibles sont transférées dans le registre R$_1$ et décalées vers la sortie. Une nouvelle période d'intégration I$_2$ commence pour la deuxième rangée, elle se terminera lorsque V et Ø$_2$ seront à nouveau au niveau haut.

Pour faire varier la période d'intégration, on peut agir sur la période du signal d'horloge V et sur la fréquence de lecture des registres.

Pour obtenir un temps d'intégration variable autrement qu'en agissant sur les signaux de commande V, V$_1$ et V$_2$, on peut utiliser les moyens représentés sur la partie gauche de la figure 6. Ces moyens pourraient être utilisés de la même façon dans le mode de réalisation de la figure 5 ou dans d'autres modes de réalisation de l'invention. Sans ces moyens, le temps d'intégration est toujours égal au minimum à la somme des deux temps de lecture J$_1$ et J$_2$. Ces moyens permettent de diminuer le temps d'intégration au-delà de cette limite.

Ces moyens sont constitués par un drain d'évacuation des charges D et par une grille G$_D$ qui contrôe le passage entre le point photosensible et le drain.

Sur la figure 6, ces moyens sont logés dans l'espace compris entre la barrette et le registre R$_1$.

Les moyens représentés sur la partie gauche de la figure 6 permettent d'obtenir un temps d'intégration variable pour les deux points photosensibles N-1 et N+1. La grille G$_D$ a une forme sensiblement en équerre, l'une des branches de l'équerre coupe la zone conductrice 3 reliée au point photosensible N+1 alors que l'autre branche de l'équerre est parallèle à la zone conductrice 3 reliée au point photosensible N-1. Le drain D a également une forme sensiblement en équerre. Les deux branches de l'équerre constituant le drain D sont sensiblement perpendiculaires aux deux branches de l'équerre constituant la grille G$_D$.

La figure 9a représente une vue en coupe transversale des moyens associés au point photosensible N+1, du point photosensible N+1 et de la partie du registre R$_2$ à laquelle ce point est relié.

La figure 9b représente l'évolution des potentiels de surface dans le substrat semi-conducteur dans lequel est intégré le dispositif de la figure 9a à divers instants.

On suppose qu'il s'agit d'un substrat de type P et les potentiels de surface croissant sont dirigés vers le bas.

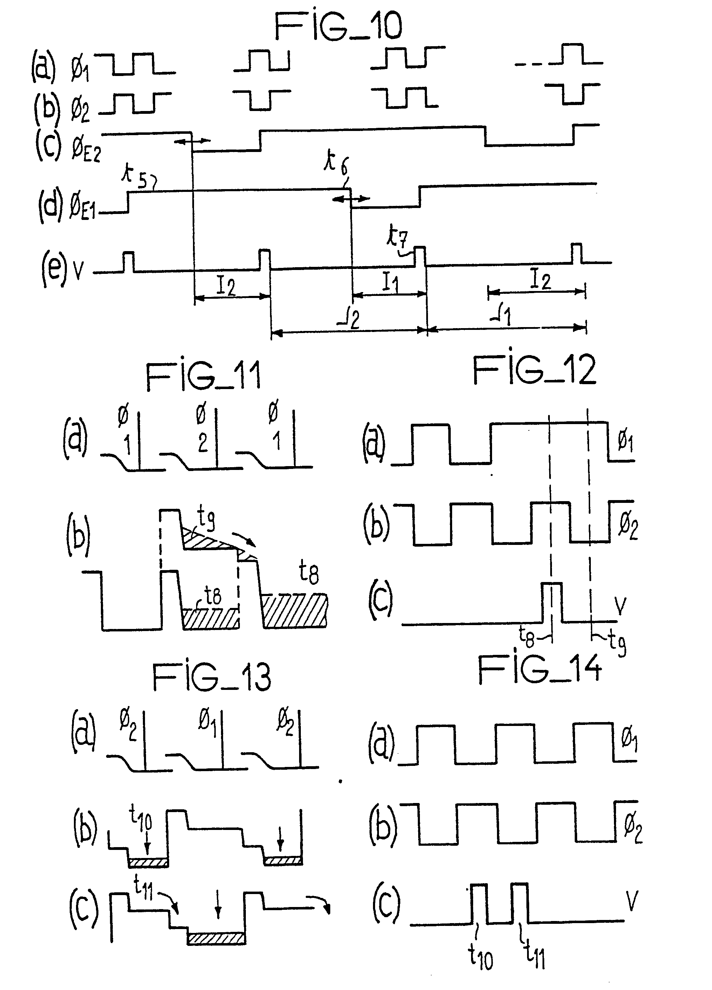

La grille G$_D$ et le drain D de ces moyens reçoivent un signal de commande Ø$_{E1}$ qui est représenté sur la figure 10d. A l'instant t$_5$, le

signal $\emptyset_{E1}$ est au niveau haut, le potentiel de surface sous la grille $C_D$ et le drain D sont représentés en trait continu sur la figure 9b. Il y a transfert vers le drain des charges injectées par le rayonnement dans la photodiode $N+1$. Ce transfert se poursuit jusqu'à l'instant $t_6$ où $\emptyset_{E1}$ passe au niveau bas. Le potentiel existant à $t_6$ sous $G_D$ et D est représenté en pointillés sur la figure 9b. C'est seulement à l'instant $t_6$ que commence la période d'intégration $I_1$ de la première rangée, cette période se termine à l'instant $t_7$ lorsque V et $\emptyset_2$ sont au niveau haut ce qui provoque le transfert des charges de la première rangée dans le registre.

On constate donc que pour modifier la période d'intégration de la première rangée, il suffit de modifier la durée de passage au niveau haut du signal $\emptyset_{E1}$.

Pour que le temps d'intégration $I_2$ des points photosensibles de la deuxième rangée soit modifié de la même façon que le temps d'intégration $I_1$, on applique aux grilles contrôlant le passage entre les points photosensibles de la deuxième rangée et un drain d'évacuation, un signal d'horloge $\emptyset_{E2}$, décalé par rapport à $\emptyset_{E1}$, mais qui reste au niveau haut pendant une durée égale au passage au niveau haut de $\emptyset_{E1}$.

Il faut signaler que lesdits moyens peuvent aussi être utilisés pour évacuer les charges en excès pendant la période d'intégration des points N-1 ou N+1.

Sur la figure 9b, on a représenté en pointillés le potentiel de surface sous la diode D et la grille $G_D$ lorsque $\emptyset_{E1}$ est au niveau bas, au temps $t_6$, alors que commence l'intégration des charges dans le point photosensible N+1.

Si le point N+1 est suréclairé, les charges en excès sont évacuées par dessus la grille $C_D$ vers le drain D.

Lesdits moyens ont donc au moins l'une des deux fonctions suivantes selon le signal de commande appliqué:
 - évacuation des charges en excès pendant le temps d'intégration;
 - réglage du temps d'intégration en évacuant les charges provenant des éléments photosensibles pendant une partie du temps d'intégration.

Dans le cas du dispositif selon l'invention représenté sur la figure 6, il est possible de disposer aisément de deux résolutions différentes. Pour cela, on peut provoquer le transfert simultanément dans chaque étage du registre des charges accumulées dans la première rangée d'éléments, et dans la deuxième rangée d'éléments. Les deux parties de chaque étage du registe contiennent alors des charges et lorsqu'on transfère ces charges vers la sortie, il y a sommation des charges contenues dans deux parties voisines, ce qui provoque la sommation des informations fournies par deux points voisins appartenant l'un à la première rangée et l'autre à la deuxième rangée.

Sur les figures 12a et b, on a représenté les signaux de commande $\emptyset_1$ et $\emptyset_2$ du registre $R_1$.

Pour diminuer la résolution, on supprime un passage au niveau bas du signal $\emptyset_1$. Au temps $t_8$, $\emptyset_1$, $\emptyset_2$ et V sont au niveau haut. Il y a transfert dans le registre des charges provenant de la première et de la deuxième rangées d'éléments photosensibles. Au temps $t_9$, $\emptyset_1$ est au niveau haut et $\emptyset_2$ et V sont au niveau bas.

Comme cela est représenté sur la figure 11b, il y a sommation sous les électrodes de stockage reliées à $\emptyset_1$ des charges se trouvant sous les électrodes de stockage reliées à $\emptyset_1$ et $\emptyset_2$ et qui sont représentées sur la figure 11a.

On peut aussi obtenir un dispositif ayant deux résolutions différentes sans modifier les signaux $\emptyset_1$ et $\emptyset_2$. Il faut simplement générer deux impulsions V consécutives, l'une au temps $t_{10}$ alors que $\emptyset_2$ est au niveau haut et l'autre au temps $t_{11}$ proche de $t_{10}$ alors que $\emptyset_2$ est passé au niveau bas et que $\emptyset_1$ est au niveau haut. Les signaux $\emptyset_1$, $\emptyset_2$ et V sont représentés sur les figures 14a,b et c. Au temps $t_{10}$, il y a transfert sous les électrodes de stockage reliées à $\emptyset_2$ des charges provenant de l'une des rangées de la zone photosensible.

Au temps $t_{11}$, les charges stockées sous les électrodes reliées à $\emptyset_2$ sont transférées sous les électrodes de stockage reliées à $\emptyset_1$ qui reçoivent les charges provenant de l'autre rangée de la zone photosensible.

Ces mouvements de charges sont représentés sur les figures 13 b et c.

Il y a donc transfert dans chaque étage du registre successivement des charges accumulées dans la première et la deuxième rangée d'éléments photosensibles et sommation des charges recueillies sur deux éléments photosensibles voisins appartenant à deux rangées différentes.

**Revendications**

1. Dispositif photosensible à transfert de charge pour l'analyse d'images, ligne après ligne, comportant:
 - une barrette (1) d'éléments photosensibles;
 - au moins un registre à décalages à transfert de charge à entrées parallèles et sortie série ($R_1$), deux lectures successives du registre concernant une même ligne de l'image, caractérisé en ce que:
 - un elément photosensible sur deux est décalé dans la direction d'analyse de l'image, les éléments étant répartis sur une première et une deuxième rangée;
 - des moyens assurent, pour une ligne analysée, le transfert dans le registre et la lecture, successivement, des charges dues à cette ligne et accumulées dans la première rangée d'éléments pendant une durée d'intégration donnée ($I_1$), puis, des charges dues à cette ligne et accumulées dans la deuxième rangée d'éléments, pendant la même durée d'intégration ($I_2$).

2. Dispositif selon la revendication 1, caractérisé en ce qu'il comporte deux registres à décalage à transfert de charge ($R_1$, $R_2$) chaque registre traitant des éléments photosensibles appartenant à la première et à la deuxième rangée.

3. Dispositif selon l'une des revendications 1 ou 2, caractérisé en ce que chaque étage des registres utilisés comporte deux entrées des charges et en ce que les entrées des registres sont reliées alternativement à la première et à la deuxième rangée d'éléments photosensibles.

4. Dispositif selon la revendication 3, caractérisé en ce que les registres à décalages à transfert de charge fonctionnent en monophasé et en ce que lesdits moyens comportent, pour chaque élément photosensible, une grille ($G_1$, $G_2$, $G_3$...) qui contrôle le passage des charges de la barrette vers le registre.

5. Dispositif selon la revendication 3, caractérisé en ce que les registres à décalages à transfert de charge fonctionnent en polyphasé et en ce que lesdits moyens comportent, pour chaque registre, une seule grille (G) qui contrôle le passage des charges de la barette vers le registre.

6. Dispositif selon l'une des revendications 1 à 5, caractérisé en ce qu'il comporte, à proximité de chaque élément photosensible, un drain d'evacuation des charge (D) séparé de l'élément photosensible par une grille ($G_D$) recevant un signal de commande ($\emptyset_{E1}$, $\emptyset_{E2}$), l'ensemble assurant au moins l'une des deux fonctions suivantes selon le signal de commande appliqué:
- évacuation des charges en excès pendant le temps d'intégration;
- réglage du temps d'intégration en évacuant les charges provenant des éléments photosensibles pendant une partie du temps d'intégration.

7. Dispositif selon la revendication 3 et selon l'une des revendications 1 à 6, modifié en ce que lesdits moyens n'assurent pas, pour une ligne analysée, le transfert dans le registre et la lecture, successivement des charges dues à cette ligne et accumulées dans la première rangée d'éléments, puis, des charges dues à cette ligne et accumulées dans la deuxième rangée d'éléments, mais lesdits moyens assurent le transfert simultané dans chaque étage du registre de charges accumulées dans la première et dans la deuxième rangée d'éléments et enfin le transfert des charges vers la sortie du registre, ce qui provoque la sommation des charges recueillies sur deux éléments photosensibles voisins appartenant à des rangées différentes.

8. Dispositif selon la revendication 3 et selon l'une des revendications 1 à 6, modifié en ce que lesdits moyens n'assurent pas, pour une ligne analysée, le transfert dans le registre et la lecture, succesivement des charges dues à cette ligne et accumulées dans la première rangée d'éléments, puis, des charges dues à cette ligne et accumulées dans la deuxième rangée d'éléments, mais lesdits moyens assurent le transfert dans chaque étage du registre successivement des charges accumulées dans la première et dans la deuxième rangée d'éléments et le transfert des charges vers la sortie du registre, ce qui provoque la sommation des charges recueillies sur deux éléments photosensibles voisins appartenant à des rangées différentes.

9. Dispositif selon l'une des revendications 1 à 8, caractérisé en ce que le décalage entre les deux rangées d'éléments photosensibles est égal à la moitié de la dimension des éléments photosensibles dans la direction d'analyse de l'image.

10. Dispositif selon l'une des revendications 1 à 9, caractérisé en ce que les éléments photosensibles sont des photodiodes.

**Claims**

1. Photosensitive charge transfer device for the line-by-line analysis of images, comprising:
- a bar (1) of photosensitive elements:
- at least one charge transfer shift register with parallel inputs and a serial output ($R_1$), two successive readings of the register concerning the same line of the image, characterized in that:
- every second photosensitive element is shifted in the direction of image analysis, the elements being distributed in a first and a second line;
- means ensuring, for each analyzed line, the transfer into the register and the reading, successively, of the charges due to this line and accumulated in the first row of elements during a given duration of integration ($I_1$) and then of the charges due to this line and accumulated in the second row of elements during the same duration of integration ($I_1$).

2. Device according to claim 1, characterized in that it comprises two charge transfer shift registers ($R_1$, $R_2$), each register taking care of photosensitive elements belonging to the first and to the second rows.

3. Device according to any of claims 1 or 2, characterized in that each stage of the registers used comprises two inputs for the charges and in that the inputs of the registers are alternatingly connected to the first and to the second rows of photosensitive elements, respectively.

4. Device according to claim 3, characterized in that the charge transfer shift registers operate in the monophase mode and in that said means comprise, for each photosensitive element, a gate ($G_1$, $G_2$, $G_3$...) controlling the transfer of the charges from the bar to the register.

5. Device according to claim 3, characterized in that the charge transfer shift registers operate in the polyphase mode and in that said means comprise, for each register, a single gate (G) controlling the transfer of the charges from the bar to the register.

6. Device according to any of claims 1 to 5, characterized in that it comprises, in the vicinity of each photosensitive element, a charge evacuation drain (D) separated from the photosensitive element by a gate (G$_D$) receiving a control signal ($\Phi_{E1}$, $\Phi_{E2}$), the unit ensuring at least one of the following functions according to the control signal applied:

- evacuation of the excessive charges during the time of integration;

- adjustment of the integration time by evacuation of the charges originated from the photosensitive elements during a portion of the time of integration.

7. Device according to claim 3 and any of claims 1 to 6, modified in that said means do not ensure, for an analyzed line, the transfer into the register and the subsequent reading of the charges due to this line and accumulated in the first row of elements and then of the charges due to this line and accumulated in the second row of elements, these means rather ensuring the simultaneous transfer, into each stage of the register, of charges accumulated in the first and in the second rows of elements and finally the transfer of the charges to the output of the register, thus causing the summation of the charges obtained on two adjacent photosensitive elements belonging to different rows.

8. Device according to claim 3 and any of claims 1 to 6, modified in that said means do not ensure, for an analyzed line, the transfer into the register and the subsequent reading of the charges due to this line and accumulated in the first row of elements and then of the charges due to this line and accumulated in the second row of elements, these means rather ensuring the transfer, into each stage of the register and successively, of the charges accumulated in the first and in the second rows of elements and the transfer of the charges to the output of the register, thereby causing the summation of the charges obtained on two adjacent photosensitive elements belonging to different rows.

9. Device according to any of claims 1 to 8, characterized in that the displacement between the two rows of photosensitive elements is equal to half the dimension of the photosensitive elements in the direction of image analysis.

10. Device according to any of claims 1 to 9, characterized in that the photosensitive elements are photodiodes.

**Patentansprüche**

1. Photoempfindliche Ladungsverschiebevorrichtung für die zeilenweise Bildanalyse, mit:

- einer Zeile (1) von photoempfindlichen Elementen;

- wenigstens einem Ladungsverschiebe-Schieberegister mit parallelen Eingängen und seriellem Ausgang (R$_1$), wobei ein zweimaliges aufeinanderfolgendes Auslesen des Registers dieselbe Bildzeile betrifft, dadurch gekennzeichnet, daß:

- jedes zweite photoempfindliche Element in Richtung der Bildanalyse versetzt ist, wobei die Elemente auf eine erste und eine zweite Reihe verteilt sind;

- für eine analysierte Zeile gewährleisten Mittel die Überführung und anschließend das Auslesen der auf dieser Zeile beruhenden Ladungen, die in der ersten Reihe von Elementen während einer gegebenen Integrationsdauer (I$_1$) angesammelt wurden, und anschließend der auf diese Zeile zurückzuführenden Ladungen, die in der zweiten Reihe von Elementen angesammelt wurden, während derselben Integrationsdauer (I$_1$).

2. Vorrichtung nach Anspruch 1, dadurch gekennzeichnet, daß sie zwei Ladungsverschiebe-Schieberegister (R$_1$, R$_2$) umfaßt, wobei jedes Register photoempfindliche Elemente verarbeitet, welche der ersten und der zweiten Reihe zugehörig sind.

3. Vorrichtung nach Anspruch 1 oder 2, dadurch gekennzeichnet, daß jede Stufe der verwendeten Register zwei Ladungseingänge aufweist und daß die Registereingänge abwechselnd mit der ersten und mit der zweiten Reihe von photoempfindlichen Elementen verbunden sind.

4. Vorrichtung nach Anspruch 3, dadurch gekennzeichnet, daß die Ladungsverschiebe-Schieberegister einphasig arbeiten und daß die genannten Mittel für jedes photoempfindliche Element eine Steuerelektrode (G$_1$, G$_2$, G$_3$...) umfassen, welche den Übergang der Ladungen von der Zeile zu dem Register steuert.

5. Vorrichtung nach Anspruch 3, dadurch gekennzeichnet, daß die Ladungsverschiebe-Schieberegister vielphasig arbeiten und daß die genannten Mittel für jedes Register eine einzige Steuerelektrode (G) umfassen, welche den Übergang der Ladungen der Zeile zu dem Register steuert.

6. Vorrichtung nach einem der Ansprüche 1 bis 5, dadurch gekennzeichnet, daß sie in der Nähe jedes photoempfindlichen Elementes eine Ladungsabführungssenke (D) aufweist, die von dem photoempfindlichen Element durch eine Steuerelektrode (G$_D$) getrennt ist, welche ein Steuersignal ($\Phi_{E1}$, $\Phi_{E2}$) empfängt, wobei die gesamte Einheit wenigstens eine der zwei folgenden Funktionen erfüllt, je nach dem angelegten Steuersignal:

- Abführung der überschüssigen Ladungen während der Integrationszeit;

- Einstellung der Integrationszeit, indem die von den photoempfindlichen Elementen herrührenden Ladungen während eines Teils der Integrationszeit abgeführt werden.

7. Vorrichtung nach Anspruch 3 und einem der Ansprüche 1 bis 6, dahingehend verändert, daß die genannten Mittel für eine analysierte Zeile nicht die Überführung und anschließend das Auslesen der auf dieser Zeile beruhenden Ladungen, welche in der ersten Reihe von Elementen angesammelt sind, und anschließend der auf dieser Zeile beruhenden Ladungen, die in der zweiten Reihe von Elementen angesammelt sind, gewährleisten, sondern diese Mittel die gleichzeitige Überführung von in der ersten und in der zweiten Reihe von Elementen angesammelten Ladungen in jede Stufe des Registers und schließlich die Überführung der Ladungen zum Ausgang des Registers gewährleisten, wodurch die Summierung der an zwei benachbarten photoempfindlichen Elementen, die zu verschiedenen Reihen gehören, abgenommenen Ladungen verursacht wird.

8. Vorrichtung nach Anspruch 3 und nach einem der Ansprüche 1 bis 6, dahingehend verändert, daß die genannten Mittel nicht für eine analysierte Zeile die Überführung und das anschließende Auslesen der auf dieser Zeile beruhenden Ladungen, die in der ersten Reihe von Elementen angesammelt wurden, und anschließend der auf dieser Zeile beruhenden Ladungen, die in der zweiten Reihe von Elementen angesammelt wurden, in das Register verursachen, sondern diese Mittel die Überführung der in der ersten und in der zweiten Reihe von Elementen angesammelten Ladungen nacheinander in jede Stufe des Registers und die Überführung der Ladungen zum Ausgang des Registers gewährleisten, wodurch die Summierung der Ladungen verursacht wird, welche an zwei benachbarten photoempfindlichen Elementen abgenommen werden, die zu verschiedenen Reihen gehören.

9. Vorrichtung nach einem der Ansprüche 1 bis 8, dadurch gekennzeichnet, daß die Versetzung zwischen zwei Reihen von photoempfindlichen Elementen gleich der Hälfte der Abmessung der photoempfindlichen Elemente in der Bildanalyserichtung ist.

10. Vorrichtung nach einem der Ansprüche 1 bis 9, dadurch gekennzeichnet, daß die photoempfindlichen Elemente Photodioden sind.

# FIG_1

$R_2$

$N+1$ | $N+2$ | $N+3$ | $N+4$ | $N+5$ | $N+6$ | $N+7$ | $N+8$ | $N+9$ | $N+10$ | $N+11$ | $N+12$

$N$

1ère rangée

2ème rangée

$R_1$

# FIG_2

Intégration 1ère rangée

transfert et lecture 1ère rangée

Intégration 2ème rangée

transfert et lecture 2ème rangée

# FIG_3

$R_2$

un étage

$N+1$ | $N+2$ | $N+3$ | $N+4$ | $N+5$ | $N+6$ | $N+7$ | $N+8$ | $N+9$ | $N+10$ | $N+11$ | $N+12$

$N$

$R_1$

un étage

1

# FIG_4

(d)

(b)

$\phi_S$

# FIG_5

# FIG_6

FIG_7

FIG_8

FIG_9

7

FIG_10

FIG_11

FIG_12

FIG_13

FIG_14